# FASCICULE DE BREVET EUROPEEN

(11) **EP 0 723 142 B1**
(45) Date de publication et mention de la délivrance du brevet: **18.08.1999**
(21) Numéro de dépôt: 95420364.2
(22) Date de dépôt: 19.12.1995
(51) Int. Cl.: G01J 5/06, F25D 19/00, H01L 31/024

(54) **Dispositif de détection d'ondes électromagnétiques,et notamment de rayonnements infra-rouges**
Vorrichtung zur Detektion elektromagnetischer Wellen und insbesondere der Infrarotstrahlen
Device for detection of electromagnetic waves, and especially of infrared radiation

(30) Priorité: 20.01.1995 FR 9500861
(43) Date de publication de la demande: 24.07.1996
(73) Titulaire: SOCIETE FRANCAISE DE DETECTEURS, INFRAROUGES- SOFRADIR, F-92290 Chatenay Malabry (FR)
(72) Inventeur: Montanari, Jean-Louis, F-38320 Herbeys (FR)
(74) Mandataire: Vuillermoz, Bruno

(56) Documents cités:
- EP-A- 0 395 487
- EP-A- 0 419 371
- EP-A- 0 485 312
- EP-A- 0 571 907
- FR-A- 2 629 912
- US-A- 5 146 303

## Description

L'invention concerne un détecteur d'ondes électromagnétiques, et plus particulièrement un détecteur de rayonnement infra-rouge.

De manière connue et le plus souvent, les détecteurs infra-rouges fonctionnent à basse température, c'est à dire typiquement à des températures comprises entre 50 et 200 Kelvins. De fait, le dispositif détecteur proprement dit est généralement associé à une enceinte cryostatique (cryostat), permettant, en fonction de la température d'utilisation du détecteur, de refroidir ce dernier par l'intermédiaire d'un doigt froid, alimenté soit par de l'hélium liquide, soit par de l'air liquide, soit par de l'azote liquide, voire encore par un dispositif cryogénérateur.

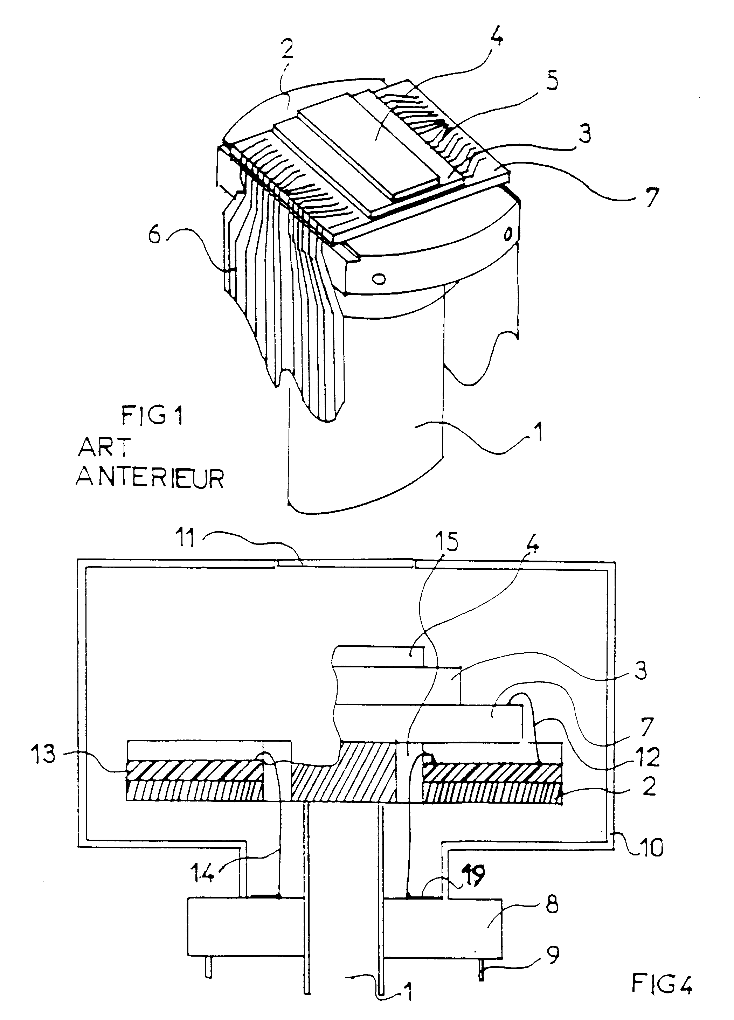

Il va être abordé ci-après en liaison avec la figure 1 représentant un détecteur infra-rouge de l'art antérieur, le domaine technique de l'invention.

L'échange thermique entre le détecteur proprement dit et le cryostat s'effectue généralement par l'intermédiaire d'un doigt froid (1) en contact direct avec la source cryogénératrice, dont l'extrémité est obturée hermétiquement, et au contact de laquelle est assujetti un plan froid (2), constitué généralement d'une pièce métallique ou céramique, fixée au doigt froid par collage ou brasure.

Dans certains cas, le plan froid (2) assure lui-même l'étanchéité du doigt froid (1). Ce plan froid est destiné à recevoir le bloc de détection, c'est à dire l'ensemble constitué par d'une part, au moins un circuit électronique de détection (4) d'ondes électromagnétiques, transformant de manière connue un rayonnement électromagnétique en un signal électrique, associé à un circuit de lecture (3), susceptible de transformer les signaux électriques issus du circuit de détection (4), notamment en les amplifiant pour les rendre susceptibles d'un traitement ultérieur. Le plan froid (2) assure en outre le transfert thermique entre le doigt froid (1) du cryostat et ledit bloc de détection.

Dans la plupart des détecteurs infra-rouges aujourd'hui mis en oeuvre, le circuit de détection (4) est hybridé au circuit de lecture (3), par exemple au moyen de microbilles d'indium. De même, il peut y avoir plusieurs circuits de détection sur un même circuit de lecture. En outre, dans d'autres applications peuvent également être prévus plusieurs circuits de lecture et plusieurs circuits de détection interconnectés par hybridation par l'intermédiaire d'un réseau d'interconnexion électrique sous-jacent par rapport auxdits circuits de détection et de lecture, le réseau d'interconnexion comportant des plots ou des pistes métallisés afin d'assurer la conduction électrique entre lesdits circuits.

Dans la plupart des cas, le bloc de détection (3, 4) est fixé mécanique ment à un circuit de connectique (7) constituant un ensemble dénommé assemblage focal, le circuit de connectique étant lui-même constitué d'une plaque en un matériau isolant présentant à sa surface supérieure, c'est à dire destinée à venir au contact du bloc de détection, des pistes et des plots métalliques (5) permettant également la soudure de microfils (6). Ce circuit de connectique (7) a pour fonction d'assurer le transfert des signaux électriques du circuit de lecture (3) vers la connectique interne proprement dite du cryostat, elle-même reliée à un connecteur, constitué de manière connue d'une pièce permettant le transfert des signaux électriques hors du cryostat, tout en assurant l'étanchéïté de la partie interne de ce dernier vis à vis de l'extérieur. Les technologies de fabrication de ces connecteurs sont multiples et bien connues, et sont par exemples décrites dans les documents DE-A-3 344 713 et US-A-3 259 865.

Compte-tenu du mode d'interconnexion, notamment entre le bloc de détection (3, 4) ou l'assemblage focal (3, 4, 7) et le connecteur, à chaque type de détecteur est associé un cryostat, dont la géométrie est directement dépendante de la géométrie du composant qui le constitue.

De manière plus spécifique, le connecteur du cryostat, dont la fonction est de transférer les signaux électriques à l'extérieur du cryostat sans altérer l'étanchéité de celui-ci, et permettant en outre d'exploiter les signaux électriques à l'extérieur du cryostat, aux moyens de broches notamment, présente des dimensions et une configuration (nombre, positionnement des broches, etc.) directement liées à celles du détecteur. De fait, la réalisation de connecteurs spécifiques pour chacun des types de détecteurs mis en oeuvre engendre un surcoût important et des pertes de temps non négligeables. On a par exemple décrit dans le document EP-A-0 395 487 un tel dispositif, dans lequel on munit un couvercle de pistes conductrices destinées à venir en contact avec des plots de connexion du circuit de lecture, et en outre comportant des éléments de connexion élastiques venant en contact avec ces pistes, et destinés à assurer le transfert des signaux à l'extérieur du cryostat.

Il est donc apparu souhaitable de standardiser, et en tout cas d'homogénéiser les dimensions du connecteur et ce, de manière indépendante par rapport à la géométrie du détecteur mis en oeuvre, et donc de standardiser les interfaces électriques connecteur - cryostat. En d'autres termes, pour une géométrie figée du connecteur, on souhaite pouvoir associer tous types de composant constitutif du bloc de détection ou de l'assemblage focal, de dimensions variables et notamment des détecteurs de grandes dimensions, et permettant en outre de réaliser aisément les liaisons électriques entre le détecteur et le connecteur.

La connexion du bloc de détection (3, 4) ou de l'assemblage focal (3, 4, 7) à la connectique interne du cryostat nécessitent souvent l'utilisation de lignes souples comme conducteurs électriques, dont la mise en oeuvre est délicate et présente l'inconvénient rédhibitoire d'occasionner des phénomènes de dégazage sous vide importants, susceptibles donc d'affecter la durée d'utilisation sans maintenance. De plus, de telles lignes souples présentent après leur mise en place des déports également importants, susceptibles de gêner la fixation d'un écran thermique et/ou optique, dont le rôle peut s'avérer essentiel dans le cadre de l'optimisation des mesures et détections effectuées par un tel dispositif.

L'objet de l'invention est donc de proposer un dispositif de détection de rayonnements électromagnétiques et notamment infra-rouges, susceptible de s'affranchir de ces inconvénients, et notamment de proposer pour une géométrie et une configration figées de connecteurs, particulièrement un pas inter-broches et un diamètre déterminés, un composant de dimensions variables et notamment de grandes dimensions, susceptible même d'être supérieures aux dimensions propres du connecteur.

Ce dispositif de détection d'ondes électromagnétiques, et notamment de rayonnement infra-rouge fonctionnant à basse température,comprend:
- un cryostat muni d'un doigt froid destiné à assurer l'échange thermique avec une source froide;
- un plan froid, disposé de manière générale perpendiculairement par rapport au doigt froid, et fixé mécaniquement et en échange thermique avec ce dernier ;
- un bloc de détection comprenant au moins un circuit de détection proprement dit, sensible au rayonnement électromagnétique à détecter et un circuit de lecture et d'exploitation en liaison électrique avec le circuit de détection, ledit bloc de détection étant fixé mécaniquement et thermiquement sur un circuit de connectique, lui-même solidarisé au plan froid, ledit circuit de connectique assurant la conduction thermique entre ledit plan froid et le bloc de détection et étant en outre destiné à assurer le transfert des signaux électriques issus du bloc de détection vers la connectique interne du cryostat, notamment au niveau d'un connecteur, destiné de manière connue à assurer le passage étanche des conducteurs électriques à l'extérieur du cryostat,
se caractérise en ce que le plan froid est pourvu d'au moins un usinage constitué par un lamage s'étendant entre l'un de ses bords périphériques en direction du centre dudit plan froid au niveau d'une lumière traversante débouchant à l'extérieur du doigt froid lorsque le plan froid est en place à l'extrémité de ce dernier, et en ce que ledit lamage reçoit un élément de connexion relais fixé par encastrement et collage au niveau de celui-ci, ledit élément de connexion étant connectable électriquement au connecteur du cryostat au moyen d'organes de connexion transitant au travers de ladite lumière traversante, les liaisons électriques entre ledit élément et le circuit de connectique associé au bloc de détection étant réalisées au niveau de l'extrémité libre périphérique dudit élément.

En d'autres termes, l'invention consiste à proposer un plan froid usiné de telle façon à recevoir un élément de connexion supplémentaire, faisant office de relais, l'une des dimensions de cet élément de connexion étant modulable pour permettre l'adaptabilité dudit plan froid à n'importe quel type de bloc de détection et partant de détecteurs. En effet, cet élément de connexion est simplement encastrable et maintenu par collage au sein de l'usinage effectué au niveau du plan froid de telle sorte que l'on peut prévoir des éléments de connexion de différentes longueurs fonction des dimensions propres du bloc de détection ou de l'assemblage focal.

Avantageusement, ces éléments de connexion sont constitués par des céramiques comportant des pistes conductrices métallisées s'étendant parallèlement sur toute leur longueur, et donc radialement par rapport au centre du plan froid.

La manière dont l'invention peut être réalisée et les avantages qui en découlent ressortiront mieux de l'exemple de réalisation qui suit donné à titre indicatif et non limitatif à l'appui des figures annexées.

La figure 1 est comme déjà, un dispositif de détection infra-rouge selon l'art antérieur.

La figure 2 est une représentation schématique en perspective partielle d'un dispositif de détection infrarouge conforme à l'invention, muni du bloc de détection.

La figure 3 est une figure analogue à la figure 2, mais dans laquelle, pour mieux matérialiser l'invention, le bloc de détection a été escamoté.

La figure 4 est une représentation schématique en section selon la ligne II-II de la figure 2.

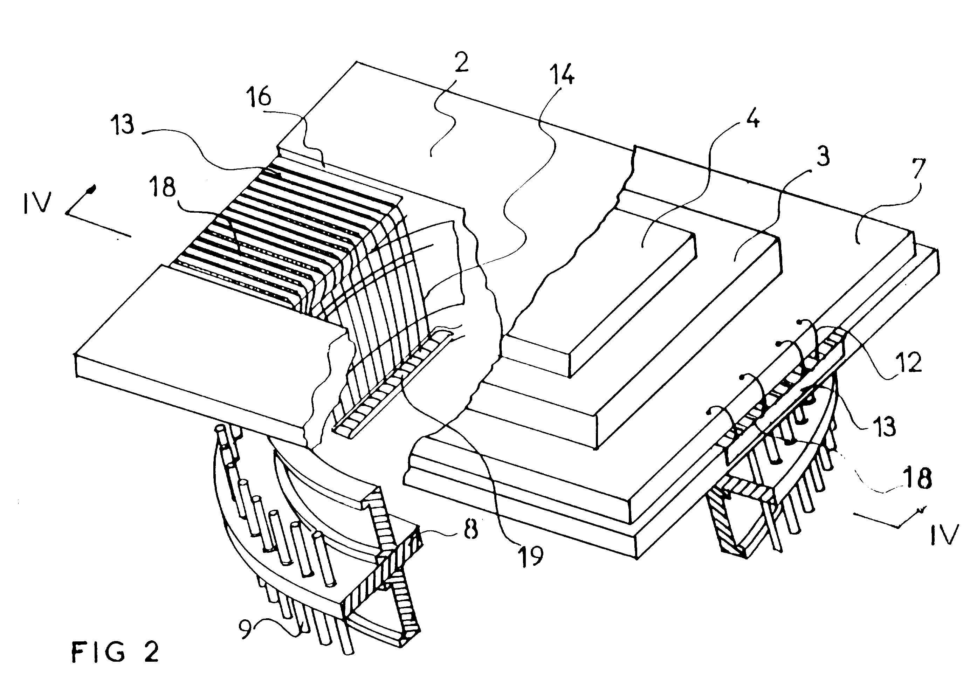

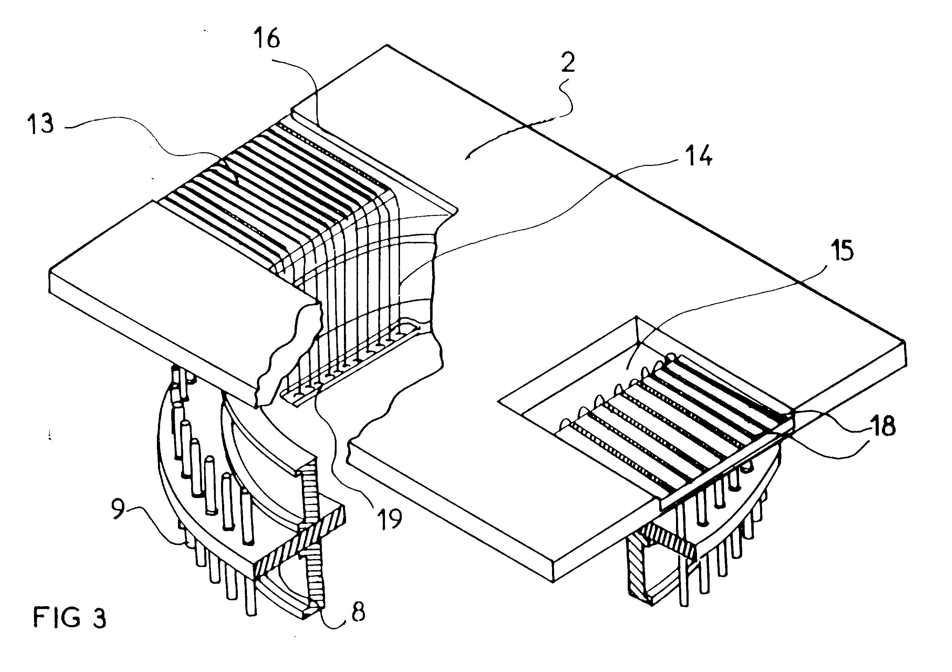

On a représenté sur les figures 2, 3 et 4, le dispositif de détection conforme à l'invention. Ce dispositif de détection infra-rouge est tout d'abord constitué d'un cryostat à double enveloppe cylindrique coaxiale, respectivement l'enveloppe externe, faisant généralement office de porte-fenêtre (10) et l'enveloppe interne constituée par le doigt froid (1). La fenêtre porte la référence (11) sur la figure 4. Le doigt froid (1) en contact direct avec une source cryogénératrice, est obturé hermétiquement par exemple par le plan froid (2), typiquement constitué d'une plaque céramique fixée par collage à l'extrémité supérieure du doigt froid, et assurant l'échange thermique avec l'assemblage focal qu'il reçoit sur sa face supérieure.

Cet assemblage focal est constitué d'une part, d'un circuit de détection proprement dit (4), typiquement constitué de barrettes ou matrices de photodiodes, connectées par hybridation notamment au moyen de micro-billes d'indium au circuit de lecture (3), lui-même fixé mécaniquement et thermiquement, en général par collage, à un circuit de connectique (7). Celui-ci est réalisé en un matériau isolant, et comporte à sa surface supérieure, c'est à dire celle destinée à venir en contact avec le circuit de lecture (3), des pistes et des plots métalliques, propres à assurer la conduction électrique.

Ce circuit de connectique (7) est fixé mécaniquement au plan froid (2) et est en échange thermique avec celui-ci, la fixation s'effectuant traditionnellement par collage, par exemple époxyde.

Selon une caractéristique fondamentale de l'invention, le plan froid (2) présente au moins un usinage en forme de lamage, et dans l'exemple décrit deux lamages (16), représentés dans la forme de réalisation mise en oeuvre symétriquement l'un par rapport à l'autre. Lesdits lamages (16) s'étendent chacun de deux bords opposés du plan froid en direction du centre de celui-ci, et débouchent chacun au niveau d'une lumière traversante (15), chacune desdites lumières (15) débouchant à l'extérieur du doigt froid (1), c'est à dire au niveau d'un diamètre supérieur à celui du doigt froid, ainsi qu'on peut par ailleurs l'observer sur la figure 4.

Ces lamages (16) sont destinés à recevoir des éléments de connexion relais (13), encastrables à leur niveau, leur fixation mécanique étant assurée par collage, époxyde par exemple. Ces éléments de connexion relais (13) constituent également une caractéristique fondamentale de l'invention.

Ces éléments de connexion relais (13) sont réalisés en un matériau isolant et par exemple par des céramiques comportant une pluralité de pistes conductrices métallisées (18) s'étendant sur toute leur longueur.

Compte tenu de la modularité des éléments de connexion relais (13), il est possible, en fonction des dimensions ou du type de détecteur utilisé, de moduler le plan froid lui-même, en encastrant et collant un ou plusieurs éléments de connexion (13) adaptés à ces dimensions ou à ce type de détecteur.

Ces éléments de connexion (13) faisant office de relais de conduction, sont reliés électriquement au circuit de connectique (7), notamment par des microfils d'or (12) de 25 µm de diamètre, soudés par ultrasons, et ce, au niveau de leur bord périphérique.

Parallèlement, lesdits éléments de connexion (13) sont également connectés au connecteur (8) au moyen de microfils d'or (14), par exemple de diamètre 25 µm, et soudés par ultrasons, fixés auxdits connecteurs (13) au niveau de leur bord interne, et venant se connecter au niveau d'un bloc connecteur (19) en transitant au travers des lumières traversantes (15), ledit bloc connecteur (19) étant de manière connue, soit directement relié au connecteur (8) et à ses broches externes (9), soit intégré au sein de celui-ci.

Compte tenu de l'encastrement des éléments de connexion relais (13) au sein des lamages (16) ménagés dans le plan froid (2), et en outre, du fait que la profondeur des lamages (16) est supérieure à l'épaisseur des céramiques de connexion relais (13), les boucles (14) de microfils de connexion ne dépassent pas le plan de collage constitué par l'interface plan froid (2) - circuit de connectique (7), et partant ne gêne pas le montage de l'assemblage focal sur le plan froid. En effet, le plan supérieur des céramiques relais (13) est inférieur au plan supérieur du plan froid (2).

De manière connue, le connecteur (8) comporte des broches de connexion (9) régulièrement réparties, permettant alors l'acheminement des signaux électriques venant du bloc connecteur (19) au niveau d'un système d'exploitation externe au cryostat.

De par l'architecture ainsi décrite, il n'est plus nécessaire de ne disposer que d'un seul gabarit de connecteur, et ainsi d'uniformiser et de standardiser ce gabarit. On peut en effet jouer dans une large gamme de dimensions des céramiques relais (13) pour adapter un ensemble cryostat-connecteur à un grand nombre de détecteurs ou assemblages focaux.

En outre, la mise en oeuvre de l'invention s'avère aisée, compte tenu de la simplification de la connectique, optimisant de la sorte la fiabilité des dispositifs de détection ainsi obtenus.

Enfin, le coût s'en trouve également réduit, d'une part compte tenu de la standardisation du connecteur ou de l'ensemble cryostat - connecteur, et d'autre part, compte tenu de l'inutilité désormais d'utiliser des lignes souples, dont l'emploi s'avère onéraux, compte tenu de leur mise en oeuvre délicate, de leur relative fragilité induisant leur remplacement périodique, mais également compte tenu d'un rendement d'assemblage nettement plus faible.

## Revendications

1. Dispositif de détection d'ondes électromagnétiques, et notamment de rayonnement infra-rouge fonctionnant à basse température, comprenant :
- un cryostat muni d'un doigt froid (1) destiné à assurer l'échange thermique avec une source froide ;
- un plan froid (2), disposé de manière générale perpendiculairement par rapport au doigt froid (2), et fixé mécaniquement et en échange thermique avec ce dernier ;
- un bloc de détection comprennant au moins un circuit de détection proprement dit (4), sensible au rayonnement électromagnétique à détecter, et un circuit de lecture et d'exploitation (3) en liaison électrique avec le circuit de détection (4), ledit bloc de détection étant fixé mécaniquement et thermiquement sur un circuit de connectique (7), lui-même solidarisé au plan froid, ledit circuit de connectique (7) assurant la conduction thermique entre ledit plan froid (2) et le bloc de détection (3, 4) et étant en outre destiné à assurer le transfert des signaux électriques issus du bloc de détection (3, 4) vers la connectique interne du cryostat, notamment au niveau d'un connecteur (8, 19), destiné de manière connue à assurer le passage étanche des conducteurs électriques à l'extérieur du cryostat,
***caractérisé*** en ce que le plan froid (2) est pourvu d'au moins un usinage constitué par un lamage (16) s'étendant entre l'un de ses bords périphériques en direction du centre dudit plan froid (2) au niveau d'une lumière traversante (15) débouchant à l'extérieur du doigt froid (1) lorsque le plan froid (2) est en place à l'extrémité de ce dernier, et en ce que ledit lamage (16) reçoit un élément de connexion relais (13) positionné par encastrement au niveau de celui-ci et fixé par collage, ledit élément de connexion relais (13) étant connecté électriquement au connecteur (8, 19) du cryostat au moyen d'organes de connexion (14) transitant au travers de ladite lumière traversante (15), les liaisons électriques entre ledit élément de connexion relais (13) et le circuit de connectique (7) étant réalisées au niveau de l'extrémité libre périphérique dudit élément (13).

2. Dispositif de détection d'ondes électromagnétiques, et notamment de rayonnement infra-rouge selon la revendication 1, *caractérisé* en ce que les éléments de connexion relais (13) sont constitués par des céramiques comportant des pistes conductrices métallisées (18) s'étendant parallèlement sur toute leur longueur, et donc radialement par rapport au centre du plan froid.

3. Dispositif de détection d'ondes électromagnétiques, et notamment de rayonnement infra-rouge selon l'une des revendications 1 et 2, *caractérisé* en ce que la profondeur des lamages (16) est supérieure à l'épaisseur des éléments de connexion relais (13).

## Patentansprüche

1. Detektoreinrichtung für elektromagnetische Wellen, und insbesondere für Infrarotstrahlung, die bei niedriger Temperatur arbeitet, mit:
- einem Kryostat mit einem kalten Stab (1), der den Wärmeaustausch mit einer Kältequelle gewährleistet;
- einer kalten Fläche (2), die im allgemeinen senkrecht zu dem kalten Stab (1) angeordnet ist und mechanisch befestigt ist und in Wärmeaustausch mit diesem steht;
- einem Detektorblock, der wenigstens eine für die zu erfassende, elektromagnetische Strahlung empfindliche Detektorschaltung im eigentlichen Sinn (4) sowie eine Ablese- und Betriebsschaltung (3) umfaßt, die elektrisch mit der Detektorschaltung (4) verbunden ist, wobei der Detektorblock mechanisch und thermisch mit einer Anschlußschaltung (7) verbunden ist, die wiederum mit der kalten Fläche verbunden ist, und wobei die Anschlußschaltung (7) die Wärmeleitung zwischen der kalten Fläche (2) und dem Detektorblock (3, 4) sicherstellt und außerdem die Übertragung der vom Detektorblock (3, 4) ausgegebenen, elektrischen Signale zum inneren Anschluß des Kryostats gewährleisten soll, insbesondere auf der Ebene eines Verbindungsteiles (8, 19), das in bekannter Weise dazu bestimmt ist, den dichten Durchgang der elektrischen Verbindungsteile an der Außenseite des Kryostats zu gewährleisten,
dadurch gekennzeichnet, daß die kalte Fläche (2) mindestens einer Bearbeitung in Form einer Absenkung (16) unterzogen wurde, die sich zwischen einem ihrer Umfangsränder in Richtung auf die Mitte der kalten Fläche (2) auf Höhe einer Durchgangsöffnung (15) erstreckt, die sich zur Außenseite des kalten Stabs (1) hin öffnet, während sich die kalte Fläche (2) am Ende des kalten Stabes befindet, und daß die Absenkung (16) ein Relaisverbindungselement (13) aufnimmt, das durch Vertiefung auf Höhe desselben positioniert und durch Verkleben befestigt wird, wobei das Relaisverbindungselement (13) elektrisch über Verbindungsorgane (14), die durch die Durchgangsöffnung (15) hindurch gehen, mit dem Verbindungsteil (8, 19) des Kryostats verbunden ist, und wobei die elektrischen Verbindungen zwischen dem Relaisverbindungselement (13) und der Anschlußschaltung (7) auf Höhe des freien Umfangsendes des Elementes ausgeführt sind.

2. Detektoreinrichtung für elektromagnetische Wellen und insbesondere für Infrarotstrahlung gemäß Anspruch 1, dadurch gekennzeichnet, daß die Relaisverbindungselemente (13) aus metallisierten Leiterstreifen (18) enthaltenden Keramikstoffen bestehen, die sich parallel über die gesamte Länge und somit radial in Bezug auf die Mitte der kalten Fläche erstrecken.

3. Detektoreinrichtung für elektromagnetische Wellen und insbesondere für Infrarotstrahlung gemäß einem der Ansprüche 1 und 2, dadurch gekennzeichnet, daß die Tiefe der Absenkungen (16) größer ist als die Dicke der Relaisverbindungselemente (13).

## Claims

1. A device for the detection of electromagnetic waves and, in particular, of infrared radiation, which operates at low temperature and comprises:
a cryostat equipped with a cold finger (1) intended to exchange heat with a cold source ;
a cold plane (2) arranged generally perpendicularly relative to the cold finger (2) and mechanically fixed to and in heat exchange with the latter ;
a detection unit comprising at least one detection circuit proper (4), sensitive to the electromagnetic radiation to be detected, and a read and analysis circuit (3) electrically connected to the detection circuit (4), said detection unit being fixed mechanically and thermally on a connection circuit (7), itself secured to the cold plane, said connection circuit (7) conducting heat between said cold plane (2) and the detection unit (3, 4) and being additionally intended to transfer the electrical signals output by the detection unit (3, 4) to the internal connection system of the cryostat, in particular at a connector (8, 19) intended in a known way to pass the electrical conductors out of the cryostat in leaktight fashion,
wherein the cold plane (2) is provided with at least one machined portion consisting of a recess (16) extending between one of its peripheral edges toward the center of said cold plane (2) in the region of a through-slot (15) opening outside the cold finger (1) when the cold plane (2) is in place at the end of the latter, and wherein said recess (16) accommodates a relay connection element (13) positioned by insertion into this recess and fixed by bonding, said relay connection element (13) being electrically connected to the connector (8, 19) of the cryostat by means of connection elements (14) passing through said through-slot (15), said relay connection element (13) being electrically connected to the connection circuit (7) at the peripheral free end of said element (13) .

2. The device for the detection of electromagnetic waves and, in particular, of infrared radiation, as claimed in claim 1, wherein the relay connection elements (13) consists of ceramics including metallized conductive tracks (18) extending parallel over their entire length, and therefore radially relative to the center of the cold plane.

3. The device for the detection of electromagnetic waves and, in particular, of infrared radiation, as claimed in one of claims 1 and 2, wherein the depth of the recesses (16) is greater than the thickness of the relay connection elements (13).
